# EUROPÄISCHE PATENTSCHRIFT

(11) **EP 3 345 302 B1**
(45) Veröffentlichungstag und Bekanntmachung des Hinweises auf die Patenterteilung: **15.04.2020**
(21) Anmeldenummer: 16760451.1
(22) Anmeldetag: 31.08.2016
(51) Int. Cl.: H03K 17/95

(54) **INDUKTIVER NÄHERUNGSSCHALTER MIT EINEM MIKROCONTROLLER**
INDUCTIVE PROXIMITY SWITCH HAVING A MICROCONTROLLER
COMMUTATEUR DE PROXIMITÉ INDUCTIF COMPRENANT UN MICROCONTRÔLEUR

(30) Priorität: 01.09.2015 DE 102015216651
(43) Veröffentlichungstag der Anmeldung: 11.07.2018
(73) Patentinhaber: IFM Electronic GmbH, 45128 Essen (DE)
(72) Erfinder: HÖSS, Heribert, 88316 Isny (DE)
(86) Internationale Anmeldenummer: PCT/EP2016/070433
(87) Internationale Veröffentlichungsnummer: WO 2017/037073

(56) Entgegenhaltungen:
- DE-A1- 19 527 174
- US-A1- 2003 034 906
- US-A1- 2006 112 290

## Beschreibung

Die Erfindung Die Erfindung betrifft einen berührungslos arbeitenden induktiven Näherungsschalter mit einem Mikrocontroller gemäß dem Oberbegriff des Anspruchs 1. Berührungslos arbeitende Näherungsschalter werden als elektronische Schaltgeräte vor allem in der Automatisierungstechnik eingesetzt. Sie sind seit langem bekannt und werden u. a. auch von der Anmelderin hergestellt und vertrieben.

Sie bestehen im Wesentlichen aus einem Sensor zur Erfassung von vorzugsweise elektrischen, aber auch optischen oder sonstigen physikalischen Eigenschaften von beweglichen Objekten, wobei die Änderung der betreffenden physikalischen Größe als Maß für die Annäherung eines Objekts dient, und einer Steuereinheit, die bei Erreichen eines Schwellwertes ein vorzugsweise binäres Schaltsignal erzeugt.

Induktive Näherungsschalter weisen mindestens eine Sensorspule auf und können sowohl mit Stromimpulsen als auch mit kontinuierlichem, meist sinusförmigen Wechselstrom betrieben werden. Dabei kann die Spule Bestandteil eines Oszillators sein und so die Frequenz bestimmen. Die Sendespule kann aber auch von einem Generator mit pulsförmigem oder sinusförmigem Strom versorgt werden.

Der Sensor kann auch als Transformator, insbesondere als Differentialtransformator aufgebaut sein und somit weitere Sende- oder Empfangsspulen aufweisen.

Ausgewertet wird die Änderung der Induktivität und/oder die Impedanz einer Spule, bzw. der Koppelfaktor zwischen zwei oder mehreren Spulen.

Um höhere und über längere Zeit auch unter wechselnden Umgebungsbedingungen konstante Schaltabstände zu erreichen, ist unbedingt eine Temperaturkompensation erforderlich.

Das kann mit Hilfe eines Temperaturfühlers und einer analogen Regelschleife geschehen. Allerdings können so nur wenige Punkte auf der Kennlinie abgeglichen werden. Das ist sowohl unzulänglich als auch für eine Großserie zu aufwändig.

Die DE 195 27 174 C2 zeigt einen induktiven Näherungsschalter mit einem Temperaturfühler, bei dem die Temperatur mit Hilfe eines A/D-Wandlers bestimmt, und in einem EPROM zur gespeichert wird. In Abhängigkeit von der erfassten Temperatur wird ein Kompensationsstrom generiert, der wiederum die Schaltschwelle beeinflusst.

Die DE 10 2004 006 901 C5 zeigt einen Induktiven Näherungsschalter, bei dem die Flussspannung von Reihe geschalteten Dioden von einem A/D-Wandler des eingebauten Mikrocontrollers ebenfalls gemessen, und einem EPROM abgelegt wird. Die Temperaturkompensation erfolgt über die Betriebsspannung des Oszillators und damit über dessen Amplitude.

Die DE 10 2013 202 573 B3 zeigt einen induktiven Näherungsschalter, bei dem der temperaturabhängige Kupferwiderstand des Spulendrahtes mit einem Lock-in-Verstärker gemessen, und der Schaltabstand auf der Grundlage dieses Messwerts durch eine Korrektur der Schaltschwelle stabilisiert wird. Das geschieht mit Hilfe einer im Gerät hinterlegten Temperaturtabelle.

Nachteilig, bzw. störend ist der erheblichen Strombedarf während der Analog-Digital-Wandlung, der sowohl den Reststrom bei Dreileiter-Geräten als auch den Mindestlaststrom bei Zweileiter-Geräten erhöht, die beide unter 500µA liegen sollen.

Die DE 100 46 147 C1 zeigt einen induktiven Näherungssensor, bei dem zwei zusätzliche Stromquellen mit positiven und negativen Temperaturkoeffizienten zur Kompensation des Temperaturgangs dienen. Hier werden der materielle Aufwand und der permanent anfallende Strombedarf als nachteilig angesehen.

Die Aufgabe der Erfindung besteht darin, den Strombedarf des Näherungsschalters zu senken, ohne auf die zur Verarbeitung von Umgebungsparametern erforderliche Analog-Digital-Wandlung von Messwerten zu verzichten.

Diese Aufgabe wird mit den kennzeichnenden Merkmalen des Patentanspruchs 1 gelöst. Die Unteransprüche betreffen die vorteilhafte Ausgestaltung der Erfindung.

Der wesentliche Erfindungsgedanke geht davon aus, dass die Analog-Digital-Wandlung nicht ständig, sondern in gewissen Zeitabständen erfolgt.

Erfindungsgemäß wird der A/D-Wandler aus einem Speicherkondensator versorgt, der über einen Widerstand von einem Pin eines den Näherungsschalter steuernden z. B. ersten Mikrocontrollers (µC), einem FPGA (Field Programmable Gate Array) oder einem ASIC (Application-Specific Integrated Circuit), gespeist wird. Der A/D-Wandler kann Bestandteil eines zweiten Mikrocontrollers oder eines beliebigen zweiten Logik-Bausteins sein.

Der Speicherkondensator wird erfindungsgemäß nur dann (auf) geladen, wenn genügend Strom zur Verfügung steht, was anhand des Programmablaufs im ersten µC oder durch

Messung, beispielsweise Überschreitung einer Komparatorschwelle erkennbar ist. Insbesondere sind das die Ruhepausen des A/D-Wandlers, aber auch die Sendepausen beim Pulsbetrieb oder auch die Dunkelphasen der LEDs.

Die Erfindung wird anhand der Zeichnung näher erläutert.

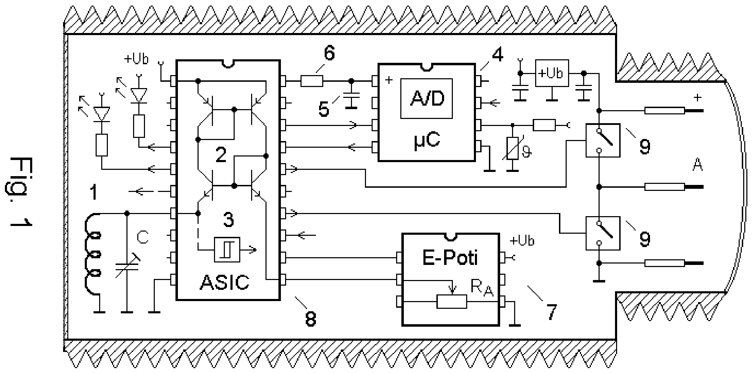

Die Fig. 1 zeigt die einen erfindungsgemäßen induktiven Dreileiter-Näherungsschalter.

Die Sensorspule 1 bildet mit dem Kondensator C einen Schwingkreis, der von einer als negativer Widerstand wirkenden Oszillatorschaltung 2 gespeist, d. h. entdämpft wird. Dargestellt ist eine Stromspiegelschaltung, die keine Spulenanzapfung benötigt und im unteren Stromspiegel eine komfortable Abgleichmöglichkeit durch einen Widerstand RA bietet. Der obere Stromspiegel dient zur Rückkopplung. Näheres ist in der DE 196 50 793 C1 offenbart.

Die Auswerteschaltung 3 steuert die Oszillatorschaltung 4, insbesondere über den Abgleichwiderstand RA, beispielsweise mit einem elektronischen Potentiometer 7 oder auch einer Widerstandsmatrix, deren Amplitude.

Die Oszillatorschaltung 2 und die Auswerteschaltung 3 sind gemeinsam in einem kundenspezifischen Schaltkreis (ASIC) untergebracht, ohne die Erfindung darauf zu beschränken. Wie oben erwähnt, enthält der ASIC eine Steuerbaugruppe mit einem Schwellwertschalter (Trigger) und einen Logik-Baustein, z. B. einen Mikrocontroller.

Da der Oszillatorstrom durch den Abgleichwiderstand RA festgelegt ist, fällt die Amplitude bei Anwesenheit eines Targets (Schaltfahne) im Überwachungsbereich, was bei Unterschreitung einer vorgegeben Schaltschwelle zur Erzeugung eines binären Schaltsignals führt. Das Schaltsignal wird über die Schalter 9 ausgegeben, die als antivalente Schalter dargestellt sind, ohne die Erfindung zu beschränken.

Darüber hinaus können mit Hilfe verschiedenfarbiger LEDs Lichtsignale erzeugt werden, die den Schaltzustand, einen Fehler, oder ein sonstiges Signal ausgeben.

Der Mikrocontroller 4 enthält einen mit A/D bezeichnete A/D-Wandler zur Erfassung eines Korrekturwerts, vorzugsweise eines Temperaturmesswertes ϑ, der zur Beeinflussung des Schaltsignals, d. h. der Amplitude oder der Schaltschwelle dient. Er ist in einem Speicher abgelegt, der im ASIC 8 oder in einem nicht dargestellten Mikrocontroller angeordnet sein kann.

Beispielsweise kann der temperaturabhängige Kupferwiderstand des Spulendrahtes gemessen und der Schaltabstand durch Korrektur der Schaltschwelle anhand einer im Mikrocontroller 4 oder im ASIC 8 hinterlegten Temperaturtabelle, oder durch die direkte Beeinflussung des Abgleichwiderstands RA stabilisiert (korrigiert) werden.

Erfindungsgemäß wird der den A/D-Wandler enthaltende Mikrocontroller 4 aus einem Speicherkondensator 5 gespeist, der über einen Widerstand 6 mit einem aktiven Anschluss, also einem (Schalt-) Ausgang des Auswerteschaltkreises 8 der im ASIC 8 angeordneten Auswerteschaltung 3 verbunden ist, und von dieser nur zeitweise (auf) geladen wird. Die Ladung erfolgt in den Zeiten, Betriebszuständen oder Phasen, in denen die Auswerteschaltung 3 einen unterdurchschnittlichen Strombedarf der gesamten Schaltung erkennt.

Da der A/D-Wandler relativ viel Strom benötigt, aber nicht ständig in Betrieb ist, weist der Mikrocontroller 4 in einer ersten Betriebsart einen höheren und in einer zweiten Betriebsart, wenn keine Analog-Digital-Wandlung erfolgt, einen deutlich geringeren Strombedarf auf. Optional wird er in einen stromsparenden Schlafmodus versetzt. Die Betriebsart des Mikrocontrollers 4 ist von der Auswerteschaltung 3 vorgegeben, wobei der Speicherkondensator 5 in der ersten Betriebsart entladen und in der zweiten Betriebsart geladen wird.

In einer weiteren Ausführung kann das Elektronische Potentiometer 7 auch direkt mit dem Mikrocontroller 4 verbunden und von diesem gesteuert sein.

Die Erfindung ist insbesondere in stromsparenden Zweileiter-Näherungsschaltern anwendbar.

### Bezugszeichenliste

- 1: Sensorspule
- 2: Oszillatorschaltung
- 3: Auswerteschaltung mit einer Logikeinheit (µC, FPGA)
- 4: Mikrocontroller, FPGA, Logik-Baustein mit einem A/D-Wandler
- 5: Speicherkondensator zur Versorgung des A/D-Wandlers
- 6: Vorwiderstand zur Begrenzung des Ladestromes für den Speicherkondensator
- 7: Elektronisches Potentiometer zur Einstellung des Schaltabstandes
- 8: Auswerteschaltkreis mit Oszillator, Trigger und Logik-Baustein (ASIC, FPGA)
- 9: Elektronische Schalter zur Erzeugung eines binären Schaltsignals
- A: Binärer Schaltausgang, optional antivalent
- RA: Abgleichwiderstand

## Patentansprüche

1. Induktiver Näherungsschalter mit mindestens einer Sensorspule (1) zur Erzeugung eines magnetischen Wechselfeldes zum Nachweis einer elektrisch leitfähigen Targets in einem Überwachungsbereich, mit einer Oszillatorschaltung (2) zur Speisung der Sensorspule (1) und einer mit der Sensorspule (1) verbundenen Auswerteschaltung (3) zur Erzeugung eines binären Schaltsignals und einem mit der Auswerteschaltung (3) verbundenen Mikrocontroller (4), wobei der Microcontroller (4) einen A/D-Wandler zur Erfassung eines Korrekturwerts aufweist, der zur Beeinflussung des Schaltsignals dient, wobei die A/D-Wandlung nur zeitweise erfolgt, **dadurch gekennzeichnet, dass** der induktive Näherungsschalter derart ausgestaltet ist, dass der Mikrocontroller (4) aus einem Speicherkondensator (5) gespeist wird, der über einen Widerstand (6) mit einem aktiven Anschluss der Auswerteschaltung (3) verbunden ist und dass der Speicherkondensator (5) von der Auswerteschaltung (3) in den Zeiten, Betriebszuständen oder Phasen geladen wird, in denen die Auswerteschaltung (3) einen unterdurchschnittlichen Strombedarf erkennt.

2. Induktiver Näherungsschalter nach Anspruch 1, **dadurch gekennzeichnet, dass** der Mikrocontroller (4) in einer ersten Betriebsart mit höheren Strombedarf und in einer zweiten Betriebsart mit geringerem Strombedarf betreibbar ist.

3. Induktiver Näherungsschalter nach Anspruch 2, **dadurch gekennzeichnet, dass** der Mikrocontroller (4) derart ausgestaltet ist, dass er in der ersten Betriebsart als A/D-Wandler arbeitet und in der zweiten Betriebsart keine A/D-Wandlung erfolgt.

4. Induktiver Näherungsschalter nach Anspruch 1 **dadurch gekennzeichnet, dass** die Auswerteschaltung (3) derart ausgestaltet ist, dass sie die Betriebsart des Mikrocontrollers (4) vorgibt.

5. Induktiver Näherungsschalter nach einem der Ansprüche 2 bis 4, **dadurch gekennzeichnet, dass** die Auswerteschaltung derart ausgestaltet ist, dass der Speicherkondensator (5) in der ersten Betriebsart entladen und in der zweiten Betriebsart geladen wird.

6. Induktiver Näherungsschalter nach einem der Ansprüche 1 bis 5, **dadurch gekennzeichnet, dass** er ein Zweileiter-Näherungsschalter ist.

## Claims

1. Inductive proximity switch, comprising at least one sensor coil (1) for generating an alternating magnetic field for determining an electrically conductive target in a monitoring region, comprising an oscillating circuit (2) for energizing the sensor coil (1) and comprising an evaluation circuit (3) connected to the sensor coil (1) for generating a binary switching signal and comprising a microcontroller (4) connected to the evaluation circuit (3), the microcontroller (4) having an A/D converter for detecting a correction value which is used to influence the switching signal, the A/D conversion being carried out only intermittently, **characterized in that** the inductive proximity switch is designed such that the microcontroller (4) is energized from a storage capacitor (5) which is connected to an active terminal of the evaluation circuit (3) via a resistor (6) and **in that** the storage capacitor (5) is charged by the evaluation circuit (3) in the times, operating conditions or phases in which the evaluation circuit (3) detects a below-average power requirement.

2. Inductive proximity switch according to claim 1, **characterized in that** the microcontroller (4) can be operated in a first operating mode with a higher power requirement and in a second operating mode with a lower power requirement.

3. Inductive proximity switch according to claim 2, **characterized in that** the microcontroller (4) is designed such that it operates as an A/D converter in the first operating mode and an A/D conversion does not take place in the second operating mode.

4. Inductive proximity switch according to claim 1, **characterized in that** the evaluation circuit (3) is designed such that it specifies the operating mode of the microcontroller (4).

5. Inductive proximity switch according to any of claims 2 to 4, **characterized in that** the evaluation circuit is designed such that the storage capacitor (5) is discharged in the first operating mode and charged in the second operating mode.

6. Inductive proximity switch according to any of claims 1 to 5, **characterized in that** it is a two-wire proximity switch.

## Revendications

1. Détecteur de proximité inductif avec au moins une bobine de capteur (1) permettant de générer un champ magnétique alternatif pour détecter une cible électriquement conductrice dans une zone de surveillance, avec un circuit oscillateur (2) permettant d'alimenter la bobine de capteur (1) et un circuit d'évaluation (3) connecté à la bobine de capteur (1) pour générer un signal de commutation binaire et un microcontrôleur (4) connecté au circuit d'évaluation (3), dans lequel le microcontrôleur (4) comporte un convertisseur A/N permettant de détecter une valeur de correction, laquelle sert à influencer le signal de commutation, dans lequel la conversion A/N n'a lieu que par moments, **caractérisé en ce que** le détecteur de proximité inductif est conçu de telle sorte que le microcontrôleur (4) est alimenté à partir d'un condensateur de stockage (5) connecté, par l'intermédiaire d'une résistance (6), à une borne active du circuit d'évaluation (3) et **en ce que** le condensateur de stockage (5) est chargé par le circuit d'évaluation (3) pendant les périodes, dans les états de fonctionnement ou pendant les phases où le circuit d'évaluation (3) détecte une demande d'électricité inférieure à la moyenne.

2. Détecteur de proximité inductif selon la revendication 1, **caractérisé en ce que** le microcontrôleur (4) peut fonctionner dans un premier mode de fonctionnement avec une demande d'électricité plus élevée et dans un second mode de fonctionnement avec une demande d'électricité plus faible.

3. Détecteur de proximité inductif selon la revendication 2, **caractérisé en ce que** le microcontrôleur (4) est conçu de manière à fonctionner comme convertisseur A/N dans le premier mode de fonctionnement, et **en ce qu'**aucune conversion A/N n'a lieu dans le second mode de fonctionnement.

4. Détecteur de proximité inductif selon la revendication 1 **caractérisé en ce que** le circuit d'évaluation (3) est conçu de manière à spécifier le mode de fonctionnement du microcontrôleur (4).

5. Détecteur de proximité inductif selon l'une des revendications 2 à 4, **caractérisé en ce que** le circuit d'évaluation est conçu de telle sorte que le condensateur de stockage (5) est déchargé dans le premier mode de fonctionnement et chargé dans le second mode de fonctionnement.

6. Détecteur de proximité inductif selon l'une des revendications 1 à 5, **caractérisé en ce qu'**il s'agit d'un détecteur de proximité à deux fils.
